# EUROPEAN PATENT SPECIFICATION

(11) **EP 1 940 024 B1**
(45) Date of publication and mention of the grant of the patent: **29.06.2011**
(21) Application number: 06301306.4
(22) Date of filing: 29.12.2006
(51) Int. Cl.: H03J 7/02

(54) **Method and apparatus for intermediate frequency selection**
Verfahren und Vorrichtung zur Zwischenfrequenzauswahl
Procédé et appareil pour une sélection de fréquence intermédiaire

(43) Date of publication of application: 02.07.2008
(73) Proprietor: Motorola Mobility, Inc., Libertyville, IL 60048 (US)
(72) Inventor: Torres, Stéphane, 31300 TOULOUSE (FR); Durand, Mathiew, 31400 TOULOUSE (FR); Muratory, Pierre, 31170 TOURNEFEUILLE (FR)
(74) Representative: Delumeau, François Guy

(56) References cited:
- US-A- 5 157 694
- US-A- 5 940 748

## Description

### FIELD OF THE INVENTION

The present invention generally relates to wireless communication devices capable of operating in Global System for Mobile communications (GSM) systems, and more particularly relates to a method and apparatus for intermediate frequency selection in a GSM wireless communication device.

### BACKGROUND OF THE INVENTION

In wireless communication devices, such as cellular telephone handsets operating in Global System for Mobile communications (GSM) systems, super heterodyne techniques are utilized in radio frequency (RF) receivers thereof to first convert received RF signals into intermediate frequency (IF) signals and then to convert the IF signals into base band signals. The intermediate frequency is the difference between the frequency of a desired RF signal and the frequency of a local oscillator. The local oscillator produces a reference signal utilized for mixer injection to translate RF signals into IF signals.

Examples of such wireless communication devices are given by the prior art documents US5157694 and US5940748

Typically, to provide a more stable demodulated signal, the RF signal is provided to a high-side demodulation path and a low-side demodulation path, the resulting signals from the two paths being recombined to provide the demodulated signal. Accordingly, the local oscillator provides a local oscillator (LO) frequency to both paths. At the high-side injection, the LO frequency is above the desired RF signal, while at the low-side injection, the LO frequency is below the desired RF signal. Thus, the LO frequency is chosen to evenly split the RF signal into a high-side RF signal and a low-side RF signal. However, the response of the receiver to the RF signal may be such that typically the adjacent channel rejection may not be symmetrical depending on the intermediate frequency. This response, which frequently occurs in GSM receivers, could lead to degradation of receiver performance.

Thus, what is needed is a method and apparatus for dynamically selecting the intermediate frequency to provide symmetrical adjacent channel rejection and improve receiver performance. Furthermore, other desirable features and characteristics of the present invention will become apparent from the subsequent detailed description of the invention and the appended claims, taken in conjunction with the accompanying drawings and this background of the invention.

### BRIEF DESCRIPTION OF THE DRAWINGS

The present invention will hereinafter be described in conjunction with the following drawing figures, wherein like numerals denote like elements, and
FIG. 1 is a block diagram of a mobile communication device in accordance with an embodiment of the present invention;
FIG. 2 is a diagram of a radio frequency (RF) receiver of the mobile communication device of FIG. 1 in accordance with the embodiment of the present invention;
FIG. 3 is a graph of one permutation of the received RF spectrum for the RF receiver of FIG. 2 in accordance with the embodiment of the present invention;
FIG. 4 is a flow chart of operation of the controller of the mobile communication device of FIG. 1 in accordance with the embodiment of the present invention; and
FIG. 5 is a depiction of the sequencing change of the intermediate frequency (IF) value of the RF receiver of FIG. 2 in accordance with the embodiment of the present invention including the RF signal and the RF spectrum and interferer graphs.

### DETAILED DESCRIPTION OF THE INVENTION

A method for demodulating a radio frequency (RF) signal in accordance with the embodiment of the present invention includes receiving information on the RF signal in a radio block comprising a plurality of consecutive bursts and determining a local oscillator reference signal for injection into the RF signal to derive an intermediate frequency (IF) signal in response to a radio block boundary of the RF signal.

A mobile communication device in accordance with the embodiment of the present invention includes receiver circuitry and a controller. The receiver circuitry is configured to receive information in a radio block having a plurality of consecutive bursts. The controller is coupled to the receiver circuitry and includes a radio link comparison module configured to determine a local oscillator reference signal for injection into the RF signal to derive an intermediate frequency (IF) signal therefrom in response to a radio block boundary of the radio block.

The following detailed description of the invention is merely exemplary in nature and is not intended to limit the invention or the application and uses of the invention. Furthermore, there is no intention to be bound by any theory presented in the preceding background of the invention or the following detailed description of the invention.

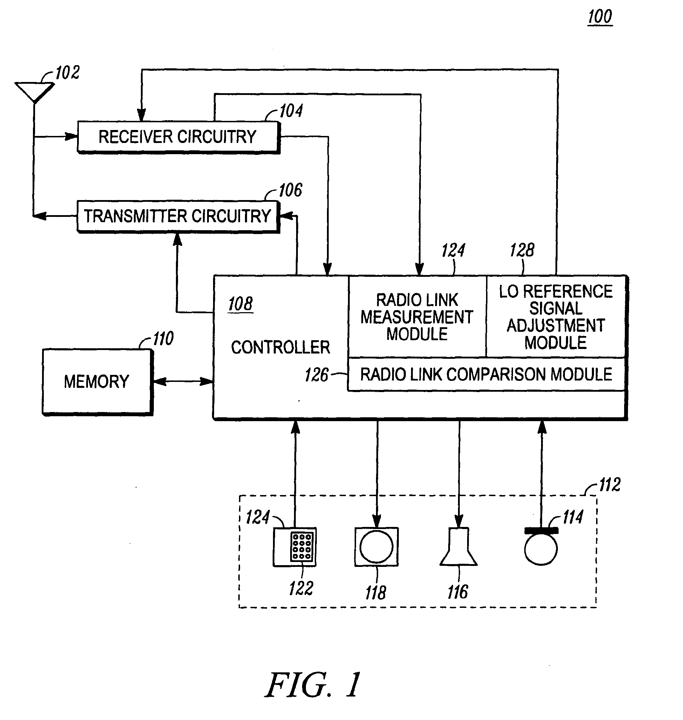

Referring to FIG. 1, a mobile communication device 100 for receiving Global System for Mobile communications (GSM) system signals in accordance with the embodiment of the present invention is shown. The wireless communication device 100 includes an antenna 102 for receiving and transmitting radio frequency (RF) signals. The antenna 102 is coupled to receiver circuitry 104 and transmitter circuitry 106 in a manner familiar to those skilled in the art. The receiver circuitry 104 demodulates and decodes received RF signals to derive information therefrom and is coupled to a controller 108 for providing the decoded information thereto for utilization thereby in accordance with the function(s) of the wireless communication device 100. The controller 108 also provides information to the transmitter circuitry 106 for encoding and modulating information into RF signals for transmission from the antenna 102. In addition, the controller 108 is coupled to the transmitter circuitry 106 to control the operation thereof in a manner well-known to those skilled in the art.

As is well-known in the art, the controller 108 is typically coupled to a memory device 110 and a user interface 112 to perform the functions of the wireless communication device 100. The user interface 112 includes a microphone 114, a speaker 116 and a display 118 which may be designed to accept touch screen inputs. The user interface 112 also includes one or more key inputs 120, including a keypad 122.

In accordance with the embodiment of the present invention, the controller 108 includes a radio link measurement module 124 coupled to the receiver circuitry 104 to measure a radio link quality based on a filtered value of a signal-to-noise ratio. In addition, the controller includes a radio link comparison module 126 and a local oscillator reference signal adjustment module 128. The radio link comparison module 126 is coupled to the receiver circuitry 104 and compares a radio link quality of the received RF signals to a predetermined quality threshold. The local oscillator reference signal adjustment module 128 is coupled to the radio link comparison module 126 and adjusts the local oscillator reference signal in response to the radio link quality being below the predetermined quality threshold, providing the adjusted local oscillator reference signal to the receiver circuitry 104 for injection into the received RF signals to derive an intermediate frequency (IF) signal.

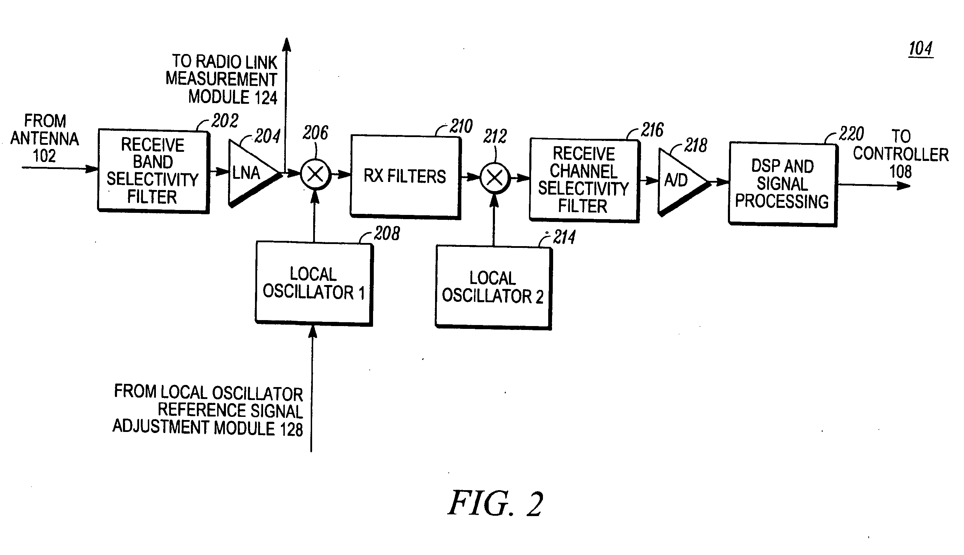

Referring to FIG. 2, a block diagram of the receiver circuitry 104 includes a first filter 202 coupled to the antenna 102 (FIG. 1) and providing receiver band selectivity filtering of the RF signals received thereby to reduce an RF spectrum of the received RF signals. The output of the filter 202 is coupled to the input of a low noise amplifier (LNA) 204 for amplification of the reduced spectrum signal.

The amplified signal is provided to a mixer 206 where a local oscillator signal from a local oscillator (LO) 208 is injected thereinto to derive an intermediate frequency signal (IF). The LO 208 receives the adjusted local oscillator reference signal from the local oscillator reference signal adjustment module 128 of the controller 108 to produce the local oscillator signal for injection into the mixer 206. Also, the amplified signal at the output of the LNA 204 is provided to the radio link comparison module 126 and the radio link measurement module 124 of the controller 108.

The intermediate frequency signal output from the mixer 206 is provided to second filters 210. The output of the one or more filters 210 is coupled to a second mixer 212 which injects a second local oscillator signal provided from LO 214 to produce a baseband frequency signal. The baseband frequency signal is provided to a third filter 216 which provides receiver channel selectivity filtering. The output of the filter 216 is provided to an analog-to-digital (A/D) converter 218 to digitize the signal and the digital signal is further processed by digital circuitry 220 for digital signal processing before being provided to the controller 108 (FIG. 1).

While simplified receiver circuitry 104 has been shown and describe in accordance with FIG. 2, those skilled in the art will realize that there are numerous receiver circuitry 104 structures including additional and/or different components which would provide demodulation and decoding of the GSM RF signals while providing amplified RF signals at the output of LNA 204 to the controller 108 for quality measurements and receive control signals at the LO 208 for control of the local oscillator signal produced thereby.

Many such structures are referred to as super-heterodyne techniques and first convert the RF signals received from the antenna 102 into IF signals (after mixer 206), and then convert the IF signals into baseband signals after mixer 212. The IF is the difference frequency between the desired RF signal and the LO frequency of the local oscillator signal from LO 208. As described above, the local oscillator signal is a reference signal provided by the LO 208 to the mixer 206 for mixer injection to translate the RF signals into the IF signals.

When the LO frequency is greater than the desired RF signal frequency, commonly referred to as high-side injection, the IF frequency is determined by subtracting the RF signal frequency from the LO frequency. Conversely, when the LO frequency is less than the desired RF signal frequency (i.e., low-side injection), the IF frequency is determined by subtracting the LO frequency from the RF signal frequency. One way of measuring the receiver 104 performance is measuring adjacent channel selectivity. Adjacent channel selectivity is the measure of the capability of the receiver 104 to receive wanted data packets without exceeding a given degradation due to the presence of an interfering signal in the adjacent channel.

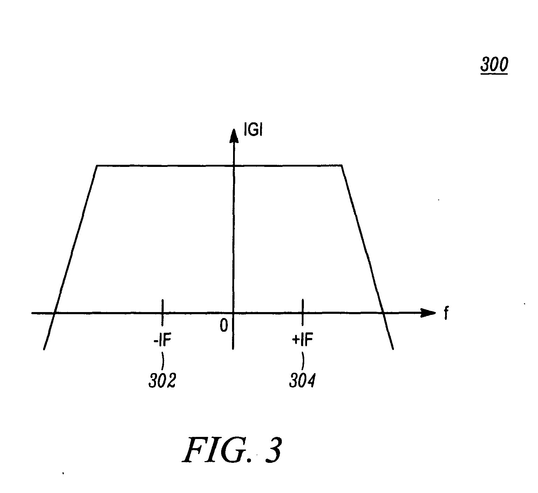

Referring to FIG. 3, a graph 300 depicts the high side injection IF 302 and the low side injection IF 304 in the situation where, due to the overall RF response of the receiver 104, adjacent channel rejection is not symmetrical. Adjacent channel rejection may not be symmetrical depending on the IF and this condition could lead to degraded receiver 104 performance. Adjacent channel rejection is usually addressed by phasing IQ imbalance and/or tuning IF value. However, when the adjacent channel rejection is not symmetrical, either of these solutions may not prevent degraded receiver 104 performance without further refinement.

In accordance with the embodiment of the present invention, changing or tuning the IF value in accordance with the structure of GSM signaling is utilized to improve adjacent channel selectivity. Digital GSM signaling communicates information in data packets as a plurality of bursts in a radio block. In accordance with third generation GSM, commonly referred to as 3GPP, a radio block is the sequence of four normal bursts carrying one radio link control (RLC) or medium access control (MAC) protocol data unit. Changing IF on a burst by burst basis is not suitable because it could lead to a bad block decoding for high modulation and coding schemes with low robustness. For example, changing the injection inside a radio block may lead to the bad decode of the block in a high coding scheme (when the redundancy is low) because at least one burst has been done with a non appropriate IF.

Thus, in accordance with the embodiment of the present invention, a local oscillator reference signal for injection into the RF signal to derive the IF signal is determined in response to a radio block boundary of the RF signal and a quality level of the RF signal. In this manner, the IF is changed by taking into account the GSM radio block constraint, as well as the RF signal quality level. If no quality threshold is used, injection side is periodic on a block basis (toggling block by block). By using a quality link threshold, the IF signal is always chosen from the best injection side. In addition, by keeping the same IF value for an entire radio block improves the block decoding because the IF is well calculated (i.e., the better injection side is chosen).

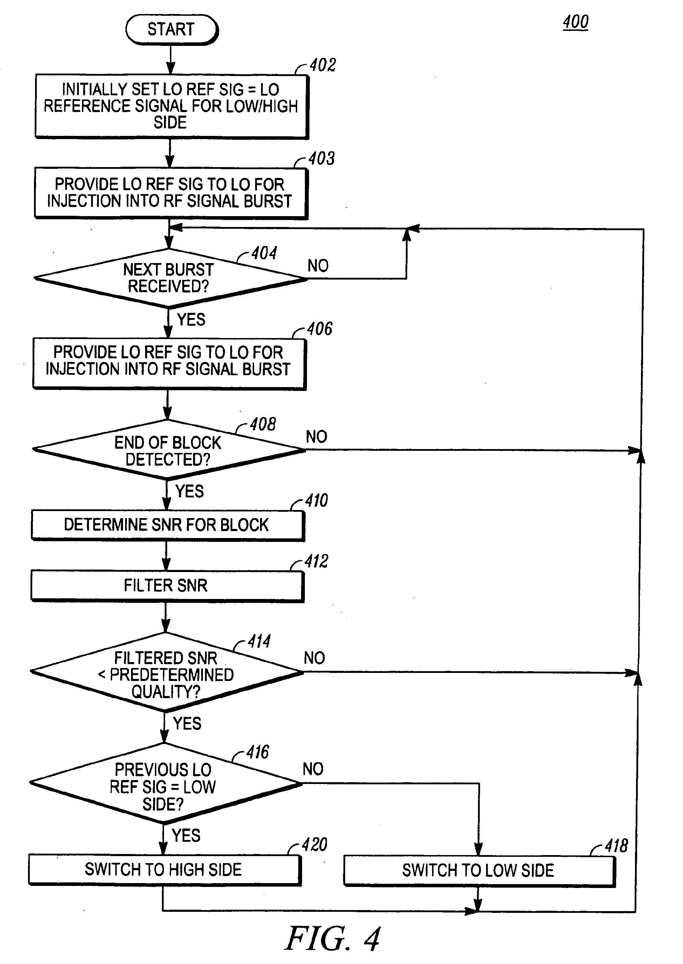

Referring to FIG. 4, a flowchart 400 of the operation of the controller 108 in accordance with the embodiment of the present invention is depicted. Operation begins by the local oscillator reference signal adjustment module 128 initially setting a LO reference signal to the LO reference signal for high side injection 402. The LO reference signal is then provided to the LO 208 for injection into the RF signal burst to derive the IF 403. Instead of setting the LO reference signal as the LO reference signal for high side injection 402, the local oscillator reference signal adjustment module 128 could set the LO reference signal to the LO reference signal for low side injection 402 without detracting from the benefits of the embodiment of the present invention. As will be recognized by those skilled in the art from a review of the flowchart 400, the initial choice of high or low side injection is not important, as the subsequent processing will track the better injection side for the IF signal generated at the output of the mixer 206.

After providing the LO reference signal 403, the controller 108 examines the signal at the output of the LNA 204 to determine when the next burst is received 404. When the next burst is received 404, the local oscillator reference signal adjustment module 128 again provides the LO reference signal to the LO 208 for injection into the RF signal burst to derive the IF 406. The controller 108 next determines if the end of the GSM block of four consecutive bursts has been detected 408. If the end of the block has not been detected 408, processing returns to await reception of the next burst 404.

When the end of the block has been detected 408, the radio link measurement module 124 calculates the radio link quality. In accordance with the embodiment of the present invention, the radio link quality indicator is a filtered value of the signal-to-noise ratio (SNR) reported for each radio block. Therefore, first, the radio link measurement module 124 determines a signal-to-noise ratio (SNR) value for the received block 410 from the information the controller 108 has obtained by monitoring the RF signal at the output of the LNA 204. Then, a filtered SNR value is derived for the radio link quality by filtering the SNR 412. The radio link comparison module 126 then compares the radio link quality to a predetermined quality threshold 414. The predetermined quality threshold could either be programmed into the radio link comparison module 126 at manufacture or calculated during factory phasing of the mobile communication device 100. If the radio link comparison module 126 determines that the radio link quality (i.e., the filtered SNR value) is above the predetermined quality threshold 414, the local oscillator reference signal adjustment module 128 maintains the LO reference signal without adjustment as processing returns to await reception of the next burst 404.

If, on the other hand, the radio link comparison module 126 determines that the radio link quality (i.e., the filtered SNR value) is below the predetermined quality threshold 414, the local oscillator reference signal adjustment module 128 adjusts the LO reference signal. The local oscillator reference signal adjustment module 128 determines whether the LO reference signal is the LO reference signal for low side injection 416. If the LO reference signal is not the LO reference signal for low side injection 416, the local oscillator reference signal adjustment module 128 adjusts the LO reference signal to the LO reference signal for low side injection 418 and processing returns to await reception of the next burst 404. Conversely, if the LO reference signal is the LO reference signal for low side injection 416, the local oscillator reference signal adjustment module 128 adjusts the LO reference signal to the LO reference signal for high side injection 420 and processing returns to await reception of the next burst 404.

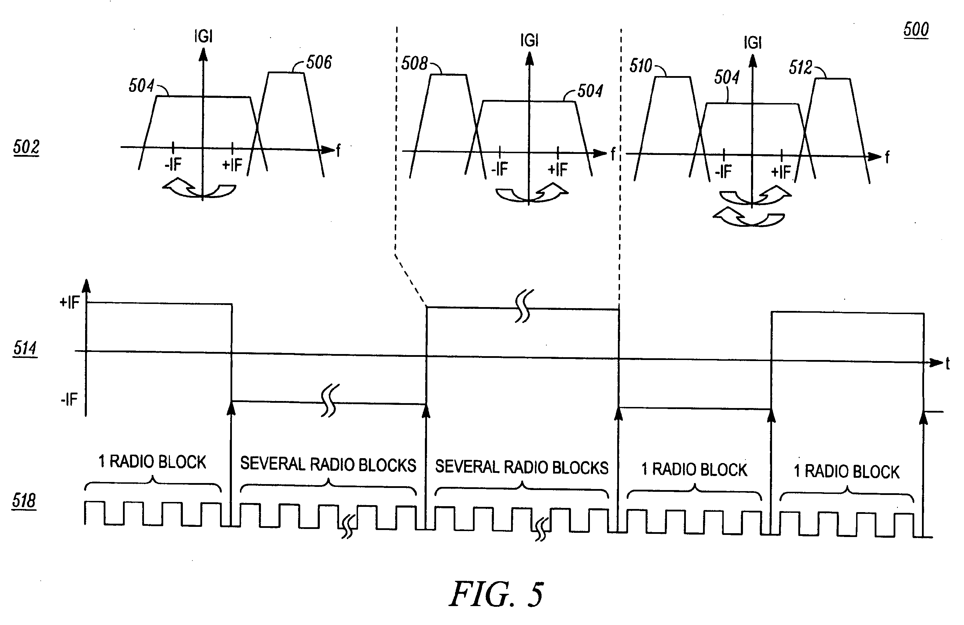

Referring to FIG. 5, graphs 502 of various permutations of the RF spectrum 504 with interferers 506, 508, 510, 512 and selection of IF values therefrom in accordance with the embodiment of the present invention are shown. Below the graphs 502, a graph 514 of the corresponding high- and low-side IF values 516 are shown. Below the IF value graph 514, the GSM signaling pattern 518 is shown with four GSM bursts 520 per one GSM radio block 522.

In the left portion 524 of FIG. 5, the interferer 506 provides interfering signals within the low-side injection IF (+IF). Accordingly, after the radio block 522 where the interferer 506 is detected, the IF value switches from low-side injection (+IF) to high-side injection (-IF) or, if already at the high-side injection, maintains the IF value for the high-side injection. As discussed above, this is performed by adjusting the local oscillator reference signal value.

Then, in the middle portion 526 of FIG. 5, the interferer 508 provides interfering signals within the high-side injection IF (-IF). Accordingly, after the radio block 522 where the interferer 508 is detected, the IF value switches from high-side injection (-IF) to low-side injection (+IF) or, if already at low-side injection, maintains the IF value for the low-side injection.

Finally, in the right portion 528 of FIG. 5, the interferers 510, 512 provide interfering signals within both the high-side injection IF (-IF) and the low-side injection IF (+IF). After each radio block 522 where one of the interferers 510, 512 is detected, the IF value switches from one IF value to the other IF value. Accordingly, as long as there are interferers 510, 512 in both the high side injection IF and the low-side injection IF, the radio link quality will remain below the predetermined quality threshold and the IF value will change at each radio block boundary.

Thus it can be seen that a method and apparatus for dynamically selecting the intermediate frequency to provide symmetrical adjacent channel rejection and improve receiver performance has been provided. While at least one exemplary embodiment has been presented in the foregoing detailed description of the invention, it should be appreciated that a vast number of variations exist. It should also be appreciated that the exemplary embodiment or exemplary embodiments are only examples, and are not intended to limit the scope, applicability, or configuration of the invention in any way. Rather, the foregoing detailed description will provide those skilled in the art with a convenient road map for implementing an exemplary embodiment of the invention, it being understood that various changes may be made in the function and arrangement of elements described in an exemplary embodiment without departing from the scope of the invention as set forth in the appended claims.

## Claims

1. A method for demodulating a radio frequency (RF) signal comprising the step of:
receiving (104) information on the RF signal in a radio block comprising a plurality of consecutive bursts;
**characterized in that** it further comprises the steps of:
determining (406) a local oscillator reference signal on a block by block basis for injection into the RF signal to derive an intermediate frequency (IF) signal for the radio block, wherein the local oscillator reference signal is one of a high-side injection signal or a low-side injection signal;
comparing (414) a radio link quality of the RF signal to a predetermined quality threshold; and
wherein the radio link quality is below the predetermined quality threshold, adjusting (418, 420) the local oscillator reference signal to another of the high-side injection signal or the low side injection signal.

2. The method in accordance with Claim 1 wherein the plurality of consecutive bursts of the radio block is four consecutive bursts.

3. The method in accordance with Claim 1 further comprising maintaining the local oscillator reference signal without adjustment during reception of a plurality of consecutive bursts of least another radio block.

4. The method in accordance with Claim 3 wherein the radio link quality is based (412) on a value of a signal-to-noise ratio measured for the radio block.

5. The method in accordance with Claim 1 further comprising the step (406) of injecting the local oscillator reference signal into the RF signal to derive the IF signal.

6. The method in accordance with Claim 5 wherein the step of injecting includes the step of mixing the local oscillator reference signal with the RF signal within the radio block with one of the plurality of consecutive bursts thereof to translate the RF signal into the IF signal.

7. The method in accordance with Claim 1 further comprising the step of adjusting the local oscillator reference signal on a block-by-block basis while maintaining the same local oscillator reference signal for the plurality of consecutive bursts of the radio block.

8. A radio frequency (RF) receiver (104) receiving an RF signal comprising information modulated thereonto in a radio block comprising a plurality of consecutive bursts, **characterized in that** the RF receiver comprising:
filtering circuitry (202) for reducing an RF spectrum of the RF signal to generate a reduced spectrum RF signal;
amplification circuitry (204) coupled to the filtering circuitry (202) and amplifying the reduced spectrum RF signal;
a mixer (206) coupled to the amplification circuitry (204) and configured to inject a first local oscillator reference signal into each of the plurality of consecutive bursts of the radio block of the reduced spectrum RF signal to derive an intermediate frequency (IF) signal therefrom; and
a controller (108) coupled to the RF receiver, the controller including a radio link comparison module (126) configured to compare a radio link quality of the RF signal to a predetermined quality threshold, the controller (108) further including a local oscillator reference signal adjustment module (128) coupled to the radio link comparison module (126) and configured to adjust the local oscillator reference signal to a second local oscillator reference signal opposite the RF signal from the first local oscillator reference signal in response to the radio link quality being below the predetermined quality threshold.

9. The RF receiver (104) of Claim 8 wherein the plurality of consecutive bursts of the radio block is four consecutive bursts.

10. The RF receiver of Claim 8 wherein the mixer (206) injects an adjusted local oscillator reference signal on the radio block boundary in response to a radio link quality of the RF signal being below a predetermined quality threshold.

11. The RF receiver (104) of Claim 10 wherein the mixer (206) injects an adjusted local oscillator reference signal on the radio block boundary in response to a value of a signal-to-noise ratio measured for the radio block being below a predetermined quality threshold.

12. The RF receiver (104) of Claim 10 wherein the mixer is further configured to maintain the same local oscillator reference signal for the plurality of consecutive bursts of the radio block.

13. The RF receiver (104) of Claim 8 wherein the mixer (206) injects the local oscillator reference signal by mixing the local oscillator reference signal with the reduced spectrum RF signal for each of the plurality of consecutive bursts of the radio block to translate the reduced spectrum RF signal into the IF signal.

14. A mobile communication device (100), comprising the RF receiver (104) of claim 8, wherein:
the radio link comparison module (126) is configured to determine the local oscillator (208) reference signal for injection into the RF signal.

15. The mobile communication device (100) of Claim 14 wherein the mixer (206) is coupled to the radio link comparison module (126) and is configured to inject the local oscillator (208) reference signal into each of the plurality of consecutive bursts of the radio block.

16. The mobile communication device (100) of Claim 15 wherein the controller (108) further includes a radio link measurement module (124) coupled to the receiver circuitry (104) to measure the radio link quality based on a filtered value of a signal-to-noise ratio measured for the radio block.

17. The mobile communication device (100) of Claim 16 wherein the local oscillator reference signal adjustment module (128) adjusts the local oscillator reference signal on a block-by-block basis while maintaining the same local oscillator reference signal for the plurality of consecutive bursts of the radio block.

18. The mobile communication device (100) of Claim 15 wherein the mixer (206) injects the local oscillator reference signal by mixing the local oscillator reference signal with the RF signal for each of the consecutive bursts of the radio block to translate the RF signal into the IF signal.

## Patentansprüche

1. Verfahren zum Demodulieren eines Funkfrequenz-(RF)-Signals, umfassend die Schritte des:
Empfangens (104) von Information auf dem RF-Signal in einem Funkblock, umfassend eine Mehrzahl von aufeinanderfolgenden Bursts;
**dadurch gekennzeichnet, daß** es ferner die folgenden Schritte umfaßt:
Bestimmen (406) eines lokalen Oszillator-Referenzsignals auf Block-zu-Bock-Basis zum Injizieren in das RF-Signal, um ein Zwischenfrequenzsignal (IF) für den Funkblock abzuleiten, wobei das lokale Oszillator-Referenzsignal ein High-Side-Injektionssignal oder ein Low-Side-Injektionssignal ist;
Vergleichen (414) der Funkverbindungsqualität des RF-Signals mit einer vorbestimmten Qualitätsschwelle; und
wenn die Funkverbindungsqualität unter die vorbestimmte Qualitätsschwelle sinkt, Anpassen (418, 420) des lokalen Oszillator-Referenzsignals an ein anderes High-Side-Injektionssignal oder Low-Side-Injektionssignal.

2. Verfahren nach Anspruch 1, wobei die Mehrzahl von aufeinanderfolgenden Bursts des Funkblocks vier aufeinanderfolgende Bursts beträgt.

3. Verfahren nach Anspruch 1, ferner umfassend das Aufrechterhalten des lokalen Oszillator-Referenzsignals ohne Anpassung während des Empfangs einer Mehrzahl von aufeinanderfolgenden Bursts mindestens eines anderen Funkblocks.

4. Verfahren nach Anspruch 3, wobei die Funkverbindungsqualität auf einem Signal-Rausch-Verhältnis-Wert basiert (412), der für den Funkblock gemessen wurde.

5. Verfahren nach Anspruch 1, ferner umfassend den Schritt (406) des Injizierens des lokalen Oszillator-Referenzsignals in das RF-Signal, um das IF-Signal abzuleiten.

6. Verfahren nach Anspruch 5, wobei der Schritt des Injizierens den Schritt des Mischens des lokalen Oszillator-Referenzsignals mit dem RF-Signal innerhalb des Funkblocks mit einem der Mehrzahl von dessen aufeinanderfolgenden Bursts beinhaltet, um das RF-Signal in das IF-Signal umzusetzen.

7. Verfahren nach Anspruch 1, ferner umfassend den Schritt des Anpassens des lokalen Oszillator-Referenzsignals auf Block-zu-Block-Basis unter Aufrechterhaltung des gleichen lokalen Oszillator-Referenzsignals für die Mehrzahl von aufeinanderfolgenden Bursts des Funkblocks.

8. Funkfrequenz-(RF)-Empfänger (104), der ein RF-Signal empfängt, das auf diesem in einem Funkblock, umfassend eine Mehrzahl von aufeinanderfolgenden Bursts, moduliert ist, **dadurch gekennzeichnet, daß** der RF-Empfänger umfaßt:
eine Filterschaltung (202) zum Reduzieren eines RF-Spektrums des RF-Signals, um ein RF-Signal mit reduziertem Spektrum zu erzeugen;
eine Verstärkungsschaltung (204), die mit der Filterschaltung (202) gekoppelt ist und das RF-Signal mit reduziertem Spektrum verstärkt;
ein Mischer (206), der mit der Verstärkungsschaltung (204) gekoppelt und dazu konfiguriert ist, ein erstes lokales Oszillator-Referenzsignal in jedes der Mehrzahl von aufeinanderfolgenden Bursts des Funkblocks des RF-Signals mit reduziertem Spektrum zu injizieren, um daraus ein Zwischenfrequenz-(IF)-Signal abzuleiten; und
eine mit dem RF-Empfänger gekoppelte Steuerung (108), die ein Funkverbindungs-Vergleichsmodul (126) enthält, das dazu konfiguriert ist, eine Funkverbindungsqualität des RF-Signals mit einer vorherbestimmten Qualitätsschwelle zu vergleichen, wobei die Steuerung (108) ferner ein Anpassungsmodul (128) für das lokale Oszillator-Referenzsignal umfaßt, welches mit dem Funkverbindungs-Vergleichsmodul (126) gekoppelt und dazu konfiguriert ist, das lokale Oszillator-Referenzsignal an ein zweites lokales Oszillator-Referenzsignal anzupassen, das dem RF-Signal aus dem ersten lokalen Oszillator-Referenzsignal gegenüber liegt, wenn die Funkverbindungsqualität unter die vorherbestimmte Qualitätsschwelle sinkt.

9. RF-Empfänger (104) nach Anspruch 8, wobei die Mehrzahl von aufeinanderfolgenden Bursts des Funkblocks vier aufeinanderfolgende Bursts beträgt.

10. RF-Empfänger nach Anspruch 8, wobei der Mischer (206) ein angepaßtes lokales Oszillator-Referenzsignal an der Funkblockgrenze injiziert, wenn eine Funkverbindungsqualität unter eine vorherbestimmte Qualitätsschwelle sinkt.

11. RF-Empfänger (104) nach Anspruch 10, wobei der Mischer (206) ein angepaßtes lokales Oszillator-Referenzsignal an der Funkblockgrenze injiziert, wenn ein für den Funkblock gemessener Signal-Rausch-Verhältnis-Wert unter eine vorherbestimmte Qualitätsschwelle sinkt.

12. RF-Empfänger (104) nach Anspruch 10, wobei der Mischer ferner dazu konfiguriert ist, das gleiche lokale Oszillator-Referenzsignal für die Mehrzahl von aufeinanderfolgenden Bursts des Funkblocks aufrechtzuerhalten.

13. RF-Empfänger (104) nach Anspruch 8, wobei der Mischer (206) das lokale Oszillator-Referenzsignal injiziert, indem er das lokale Oszillator-Referenzsignal mit einem RF-Signal mit reduziertem Spektrum für jedes der Mehrzahl von aufeinanderfolgenden Bursts des Funkblocks mischt, um das RF-Signal mit reduziertem Spektrum in das IF-Signal umzusetzen.

14. Mobiles Kommunikationsgerät (100), umfassend den RF-Empfänger (104) von Anspruch 8, wobei:
das Funkverbindungs-Vergleichsmodul (126) dazu konfiguriert ist, das Referenzsignal des lokalen Oszillators (208) zur Injizierung in das RF-Signal zu bestimmen.

15. Mobiles Kommunikationsgerät (100) nach Anspruch 14, wobei der Mischer (206) mit dem Funkverbindungs-Vergleichsmodul (126) gekoppelt und dazu konfiguriert ist, das Referenzsignal des lokalen Oszillators (208) in jeden der Mehrzahl von aufeinanderfolgenden Bursts des Funkblocks zu injizieren.

16. Mobiles Kommunikationsgerät (100) nach Anspruch 15, wobei die Steuerung (108) ferner ein an die Empfängerschaltung (104) gekoppeltes Funkverbindungs-Meßmodul (124) beinhaltet, um die Funkverbindungsqualität aufgrund eines für den Funkblock gemessenen gefilterten Signal-Rausch-Verhältnis-Wertes zu messen.

17. Mobiles Kommunikationsgerät (100) nach Anspruch 16, wobei das Anpassungsmodul (128) für das lokale Oszillator-Referenzsignal das lokale Oszillator-Referenzsignal auf Block-zu-Block-Basis anpaßt, während das gleiche lokale Oszillator-Referenzsignal für die Mehrzahl von aufeinanderfolgenden Bursts des Funkblocks aufrechterhalten wird.

18. Mobiles Kommunikationsgerät (100) nach Anspruch 15, wobei der Mischer (206) das lokale Oszillator-Referenzsignal injiziert, indem er das lokale Oszillator-Referenzsignal mit einem RF-Signal für jedes der aufeinanderfolgenden Bursts des Funkblocks mischt, um das RF-Signal in das IF-Signal umzusetzen.

## Revendications

1. Procédé de démodulation d'un signal radiofréquence (RF), comprenant l'étape de :
réception (104) d'informations sur le signal RF, dans un bloc radio comprenant une pluralité de salves consécutives ;
**caractérisé en ce qu'**il comprend en outre les étapes de :
détermination (406) d'un signal de référence d'oscillateur local, bloc par bloc, pour l'injecter dans le signal de RF afin de déduire un signal de fréquence intermédiaire (IF) pour le bloc radio, le signal de référence d'oscillateur local étant l'un d'un signal d'injection côté haut ou d'un signal d'injection côté bas ;
comparaison (414) d'une qualité de liaison radio du signal RF à un seuil de qualité prédéterminé ; et
lorsque la qualité de la liaison radio est inférieure au seuil de qualité prédéterminé, ajustement (418, 420) du signal de référence d'oscillateur local sur un autre du signal d'injection côté haut ou du signal d'injection côté bas.

2. Procédé selon la revendication 1, dans lequel la pluralité de salves consécutives du bloc radio est de quatre salves consécutives.

3. Procédé selon la revendication 1, comprenant en outre le maintien du signal de référence d'oscillateur local sans ajustement pendant la réception d'une pluralité de salves consécutives d'au moins un autre bloc radio.

4. Procédé selon la revendication 3, dans lequel la qualité de la liaison radio est obtenue (412) en fonction d'une valeur d'un rapport signal/ bruit mesuré pour le bloc radio.

5. Procédé selon la revendication 1, comprenant en outre l'étape (406) d'injection du signal de référence d'oscillateur local dans le signal RF pour déduire le signal IF.

6. Procédé selon la revendication 5, dans lequel l'étape d'injection comprend l'étape de mélange du signal de référence d'oscillateur local avec le signal RF à l'intérieur du bloc radio, avec l'une de la pluralité de salves consécutives de celui-ci, afin de transformer le signal RF en le signal IF.

7. Procédé selon la revendication 1, comprenant en outre l'étape d'ajustement du signal de référence d'oscillateur local, bloc par bloc, tout en maintenant le même signal de référence d'oscillateur local pour la pluralité de salves consécutives du bloc radio.

8. Récepteur radiofréquence (RF) (104) recevant un signal RF sur lequel sont modulées des informations, dans un bloc radio comprenant une pluralité de salves consécutives, **caractérisé en ce que** le récepteur RF comprend :
des circuits de filtrage (202) pour réduire un spectre RF du signal RF pour générer un signal RF à spectre réduit ;
des circuits d'amplification (204) couplés aux circuits de filtrage (202) et amplifiant le signal RF à spectre réduit ;
un mélangeur (206) couplé aux circuits d'amplification (204) et configuré pour injecter un premier signal de référence d'oscillateur local dans chacune de la pluralité de salves consécutives du bloc radio du signal RF à spectre réduit, pour en déduire un signal de fréquence intermédiaire (IF) ; et
un contrôleur (108) couplé au récepteur RF, le contrôleur comprenant un module de comparaison de liaison radio (126) configuré pour comparer une qualité de liaison radio du signal RF à un seuil de qualité prédéterminé, le contrôleur (108) comprenant en outre un module d'ajustement de signal de référence d'oscillateur local (128) couplé au module de comparaison de liaison radio (126) et configuré pour ajuster le signal de référence d'oscillateur local sur un deuxième signal de référence d'oscillateur local, à l'opposé du signal RF par rapport au premier signal de référence d'oscillateur local, en réponse au fait que la qualité de la liaison radio est inférieure au seuil de qualité prédéterminé.

9. Récepteur RF (104) selon la revendication 8, dans lequel la pluralité de salves consécutives du bloc radio est de quatre salves consécutives.

10. Récepteur RF selon la revendication 8, dans lequel le mélangeur (206) injecte un signal de référence d'oscillateur local ajusté à la frontière du bloc radio, en réponse au fait qu'une qualité de liaison radio du signal RF est inférieure à un seuil de qualité prédéterminé.

11. Récepteur RF (104) selon la revendication 10, dans lequel le mélangeur (206) injecte un signal de référence d'oscillateur local ajusté à la frontière du bloc radio, en réponse au fait qu'une valeur d'un rapport signal/ bruit mesuré pour le bloc radio est inférieure à un seuil de qualité prédéterminé.

12. Récepteur RF (104) selon la revendication 10, dans lequel le mélangeur est en outre configuré pour maintenir le même signal de référence d'oscillateur local pour la pluralité de salves consécutives du bloc radio.

13. Récepteur RF (104) selon la revendication 8, dans lequel le mélangeur (206) injecte le signal de référence d'oscillateur local en mélangeant le signal de référence d'oscillateur local avec le signal RF à spectre réduit pour chacune de la pluralité de salves consécutives du bloc radio, afin de transformer le signal RF à spectre réduit en le signal IF.

14. Dispositif de communication mobile (100), comprenant le récepteur RF (104) selon la revendication 8, dans lequel :
le module de comparaison de liaison radio (126) est configuré pour déterminer le signal de référence d'oscillateur local (208) afin de l'injecter dans le signal RF.

15. Dispositif de communication mobile (100) selon la revendication 14, dans lequel le mélangeur (206) est couplé au module de comparaison de liaison radio (126) et est configuré pour injecter le signal de référence d'oscillateur local (208) dans chacune de la pluralité de salves consécutives du bloc radio.

16. Dispositif de communication mobile (100) selon la revendication 15, dans lequel le contrôleur (108) comprend en outre un module de mesure de liaison radio (124) couplé aux circuits récepteurs (104) pour mesurer la qualité de la liaison radio en fonction d'une valeur filtrée d'un rapport signal/bruit mesuré pour le bloc radio.

17. Dispositif de communication mobile (100) selon la revendication 16, dans lequel le module d'ajustement de signal de référence d'oscillateur local (128) ajuste le signal de référence d'oscillateur local, bloc par bloc, tout en maintenant le même signal de référence d'oscillateur local pour la pluralité de salves consécutives du bloc radio.

18. Dispositif de communication mobile (100) selon la revendication 15, dans lequel le mélangeur (206) injecte le signal de référence d'oscillateur local en mélangeant le signal de référence d'oscillateur local avec le signal RF pour chacune des salves consécutives du bloc radio, afin de transformer le signal RF à spectre réduit en le signal IF.
